Europäisches Patentamt

European Patent Office

Office européen des brevets

(19)

(11) Publication number: **0 319 795**
**A2**

(12) **EUROPEAN PATENT APPLICATION**

(21) Application number: **88119664.6**

(22) Date of filing: **25.11.88**

(51) Int. Cl.4: **H05K 13/02 , H05K 13/00**

(30) Priority: **11.12.87 IT 2294987**

(43) Date of publication of application:
**14.06.89 Bulletin 89/24**

(84) Designated Contracting States:
**AT DE FR GB SE**

(71) Applicant: **SOLARI UDINE S.P.A.**
**Via Gino Pieri, 29**
**I-33100 Udine(IT)**

(72) Inventor: **Sandretti, Enzo**
**Via Piemonte 20**
**I-33010 Cavalicco-Tavagnacco Udine(IT)**
Inventor: **Bertossi, Bruno**
**Via Campo, 54**
**I-33013 Gemona del Friuli Udine(IT)**

(74) Representative: **Mariani, Giorgio, Dr. et al**
**INDUSTRIE PIRELLI S.p.A. Direzione Brevetti**
**Piazzale Cadorna, 5**
**I-20123 Milano(IT)**

(54) **Arrival and positioning station for axial electrical components.**

(57) Arrival and positioning station for axial electrical components (2) provided with braking means of their movement.

Such components, coming from stores through conduits (3), do not undergo, by this way, strong impacts against fixed parts of the station and can be precisely positioned for the subsequent coining and manipulation by a plier (31) brought by a robotized arm.

Fig. 1

EP 0 319 795 A2

## ARRIVAL AND POSITIONING STATION FOR AXIAL ELECTRICAL COMPONENTS

The present invention refers to an arrival and positioning station for axial electrical components, i.e. components presenting a cylindrical structure and rheophores coaxially positioned. Such stations, which are present in the apparatuses for the automatic assemblage for electrical components on printed circuit cards, receive the components, coming from suitable stores through conduits, and position them in a suitable way for their subsequent manipulation by pliers mounted on robotized arms.

The stations presently used take advantage - for the movement of the components - of an arrival conduit coming from a store, whose outlet is near to a robotized arm. Immediately outside the outlet, there is a support on which the component will be collocated after having left the duct in order to be successively coined by a plier brought by the robotized arm which thus provides to insert the component in a printed circuit card.

A centering device, for instance a piston, guarantees the movement of the component in the final part of the conduit and its correct centering on the support.

The movement of the components inside the conduit that feeds the positioning station for the axial components takes place according two different ways of functioning.

In the first way the conduit is shaped so that some compressed air thrusts the components in the conduit which is departing from the store, until the arrival of the components in correspondence of the positioning station.

In the second way of functioning, on the other hand, the movement of the components takes place simply for gravity.

Both the ways of functioning can however cause damages to the component when this enters in contact with fixed parts of the station for the subsequent positioning on the support. As a matter of fact, such damages are determined by impacts relatively violent against fixed parts of the station being these impacts practically unavoidable due to the high speed of the components movement in the conduit, particularly when they are thrust by compressed air.

The present invention aim is that of realizing a station that guarantees a soft arrival, that is without violent impacts of the component on the fixed parts of the station, with an its own subsequent precise positioning for the coining and the manipulation by the plier brought by the robotized arm.

An essential feature for a positioning and arrival station for axial electrical components according to the invention is the presence in the station of braking means for the electrical components motion.

Such braking means are advantageously applicable both to stations which are in a fixed position with respect to a robotized arm that supports the plier and to stations directly associated to the pliers mounted on a robotized arm.

Object of the present invention is an arrival and positioning station for axial electrical components, coming from a store through a conduit, for the manipulation of the same by a movable, robotized arm, comprising:
- a support for the components positioned immediately downstream the outlet end of the conduit;
- a device for the centering of the components on the support;
said station being characterized by the presence of braking means for the components positioned in a duct constituting the final part of the conduit coming from the store.

In a preferred embodiment of the invention, such means comprise:
- a shutter of the outlet end of the duct;
- an aperture provided inside the duct near the outlet end, in communication with an adjustable air blast, acting in the opposed direction to that of the motion of the arriving components.

The present invention will be better understood thanks to the following detailed description given only by way of non-limiting example and made with reference to the attached sheets of drawings, in which:
- figure 1 is a lateral, sectional view of a particular station;
- figure 2 is a frontal, sectional view of the station carried out according to the trace II-II of figure 1;
- figure 3 is a perspective view that schematizes the functioning of some elements of the particular station of figure 1.

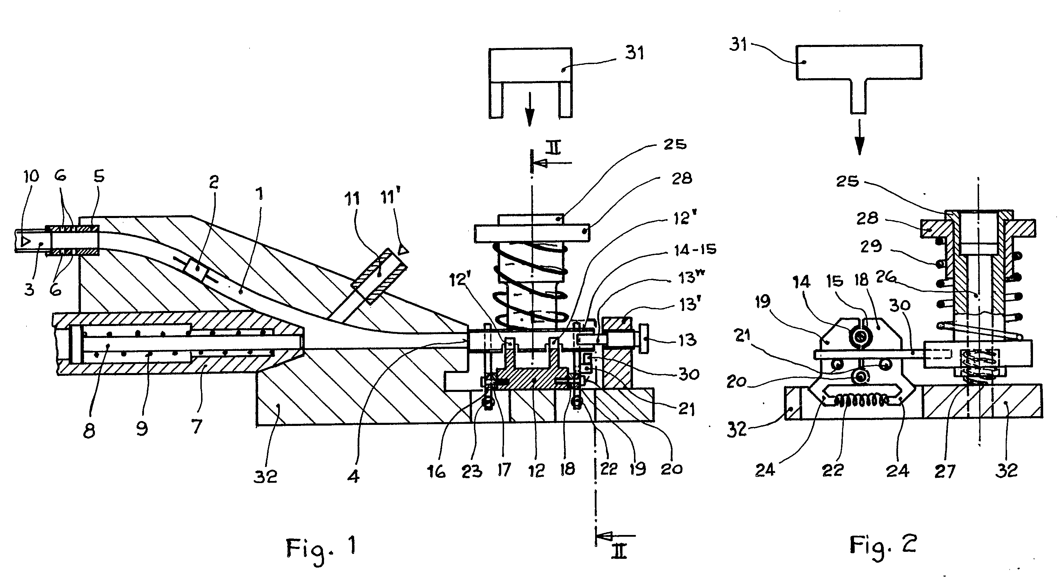

With reference to figures 1 and 2 it is now described a particular arrival and positioning station, for axial electrical components, of fixed type in respect to a robotized arm. A duct 1 allows the movement of the components 2 from its own inlet end, connected to a conduit 3, coming from a store of components not shown in figures, to its own outlet end 4 near to a robotized arm 31, being this latter per se known.

The connection between the conduit 3 and the duct 1 is realized through a sleeve 5 which presents inside its own walls four holes 6 that opens towards the outside, such a number being capable to vary freely in other embodiment forms of the invention, being in any case at least equal to one.

Adjacent to the duct 1 and in communication with it, there is a cylinder 7 inside which there is a piston 8 which slides, contrasted by a recall spring 9, being this cylinder 7 actioned by a compressed air blast not shown in figures.

Such a piston 8 can also slide in the final part of the duct 1 and, by this way, the outlet end 4 of this latter will be hermetically closed, this constituting a particular embodiment of the shutter for said outlet end 4.

A first adjustable air blast 10, is situated in the portion of the conduit 3 adjacent to the duct 1 and acts in the direction of the components movement. Moreover, an aperture 11 connected with a second adjustable air blast 11' is provided in the final portion of the duct 1 and the air of such a second air blast is flowing in the opposed direction in respect to the sense of motion of the components.

Such a second air blast associated to the aperture 11 together with the piston 8 and the sleeve 5 provided with holes allows, as will become apparent from the functioning description which follows, to realize a particular embodiment for the braking means of the components movement of the station, said braking means constituting essential feature of the present invention.

In fact, it is clear that are also possible other different braking means embodiments - according to the present invention - for instance the covering of the inner surface of the duct through suitable materials, or the insertion of sections of throttled duct, which are able to exercise friction on the component that is passing through, reducing its speed.

In the embodiment shown at figure 1, immediately outside of the outlet end 4 of the duct 1 there is a support 12 provided with flanges 12' that sustain the component 2 which has just left the duct. The correct positioning of this component is guaranteed by a small cylinder 13 which can be adjustable by a screw within a bracket 13' integral with the support 12 as it is mounted on the same base 32. The terminal part 13" of the small cylinder 13 is contained inside a housing element, constituted by a tubular body, together with the upper ends of the flanges 12' of the support 12.

The tubular body that, in this particular embodiment constitutes the end portion of the duct 1, is formed by two half tubes 14 and 15.

Such half-tubes 14 and 15, which forbide the accidental outlet of the component 2 from the support 12, normally are kept closed and are opened by an opening mechanism actioned by the movement of the robotized arm 31 that, being per se known, has only been schematized in the figures and it will not be described.

In the particular station described, the half-tubes 14 and 15 are respectively rigidly assembled to the upper part of appendixes 16, 19 and 17, 18. All these appendixes are hinged at their central part to a pin 20 of the support 12, thus realizing the reciprocal hinging of the half-tubes 14 and 15, while each of the two appendixes 18 and 19, which are farther from the duct 1, have a pin 21 for the engagement with a mechanism of aperture of the half-tubes 14 and 15 which will be described further on.

The half-tubes 14 and 15 are normally kept closed by two springs 22 and 23 acting respectively on reliefs 24 which are present in the bottom part of the appendixes 16,17 and 18, 19.

In this particular station (fig.2) the mechanism for the aperture of the half-tubes 14 and 15 comprises a column 25, subjected to the action of a first recall spring 27 and vertically sliding around to a shaft 26, situated on the same base 32 of the support 12.

Such a column 25 comprises in its upper part a disk 28 apt to be engaged by the robotized arm 31 in its own vertical motion, vertically sliding in respect to the column 25 and connected to it by a second recall spring 29 having a rigidity greater than that of the first spring 27.

Moreover the column 25 comprises in its bottom part a lever 30 rigidly connected to it which, by its own free extremity engages the pins 21 brought by the appendixes 18 and 19 assembled to the half-tubes 14 and 15.

With reference to figures 1,2 and 3, will be now described the functioning cycle of the station starting from the stage that preeceds the arrival of a component 2 in the duct 1.

In such a description reference is made to a particular axial component, that is a resistor having a diameter of 3 mm and a length of 6 mm, for the movement of which it has been proved suitable to utilize continuos pressure for certain periods of time for the first air blast 10 of the value of 8 bar and continuous pressures for certain period of time of 4 bar for the second air blast 11'.

In any case the station is even able to handle different components, applying suitable differences in the pressures involved and in their modalities of application.

Before the component 2 is entered in the duct 1, the piston 8 is completely thrust ahead thus obturating the outlet end 4 of the duct 1. Successively the second air blast 11' is brought into action through the aperture 11, that determines - in the duct - an air stream, in the opposite direction to that of the components movement, that vents towards the outside through the holes 6 of the sleeve 5.

By this way the practical realization of braking the movement of the components is got. In fact, making active the first air blast 10, the component is launched in the conduit 3. Such a component, under the thrust received from the first air blast 10, goes beyond the sleeve 5, and is braked by the air stream of the second air blast that, coming from the aperture 11, does not find any type of vent; hence, the component, being partially or completely deprived of the thrust of the first air blast, reduces first its speed, stops itself and further comes back up to the sleeve 5 and from the holes 6 of said sleeve 5 the stream of the second air blast starts again to going out thus exhausting its action of thrust.

The component 2 definitively stops its run when the values of the antithetical thrustes annul or equilibrate themselves.

The annulment of the antithetical thrustes is got by eliminating the feeding of air upstream and downstream of the component, whereas the eventual balancing can be achieved in different ways, for instance acting on the modalities (continuos or impulsive), on the volumes and/or on the pressures of the two antithetical air blasts and/or on the length of the part of the sleeve provided with holes, in relation to the axial length of the component involved.

Closing now the second air blast 11', associated to the aperture 11 and having the piston 8 moved backward, so to open again the end 4 of the duct 1, an air stream is generated through the first air blast 10 (or by a new impulse or by the effect of a continuous feeding) which gently drags with itself the component since its action of thrust is considerably reduced when the component movement makes the holes 6 of the sleeve 5 opened. In fact the air stream originated by the first air blast 10 can, at this stage, vent through the holes 6 and the component advances along, nearly for inertia, the short duct 1 up to its final part.

Now the component is moved through the end 4 of the duct 1 by piston 8, which is going ahead again, and it is centered, thanks to the small cylinder 13 - on the flanges 12' of the support 12 inside the cavity formed by two half-tubes 14 and 5 locked one to the other.

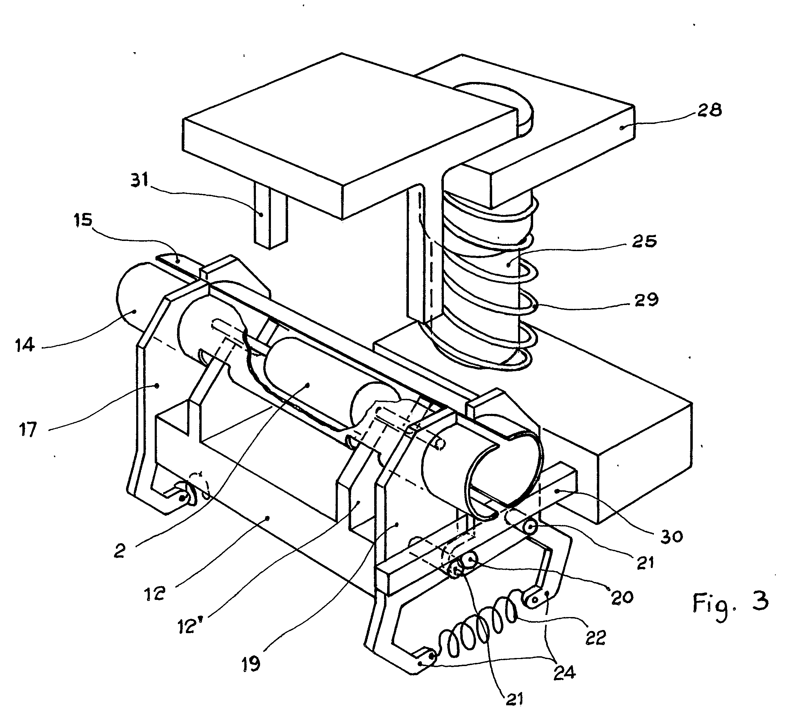

When the robotized arm 31 descends, to carry out the coining by the plier and the withdrawal of the component, the robotized arm lowers the disk 28 brought by the column 25 (this stage of the functioning is illustrated in detail at figure 3). The second spring 29 which connects the disk 28 to the column 25 does not compress itself in a first stage, as it is more rigid than the first spring 27 on which the column 25 is mounted: in such a manner - together with the disk 28 the column 25 and the lever 30 connected to column 25, are lowered, compressing the first spring 27. Further to such a motion, the lever 30 engages the pins 21 making the appendixes 18 and 19 rotated and thus also the half-tubes 14 and 15 connected to them around the pin 12, thus making evident the component 2 on which is possible to work by the robotized arm 31.

When the first spring 27 has been completely compressed, the disk 28 continues its descent but no longer integrally with the column 25 which, at this point, is leaned on the base 32, but compressing the second spring 29 and determining a storing of elastic energy from which the robotized arm 31 will take advantage in its own subsequent ascensional motion.

From the description hereabove given and from the following considerations it will become apparent that the aims of the present invention are achieved.

The presence in a station - according to the invention - of braking means for the components movement allows to avoid their damages due to the impact against any fixed part existing in the same station.

As a matter of fact, the air stream generated in the duct by the second air blast which - thanks to the closure of the outlet end of the duct by the piston - is compelled to go in the opposite direction to that of the component motion -completely annul the speed of the arriving components and even invert their running direction. It is however avoided that the components are excessively moved backward by arranging holes on the sleeve of connection between the duct and the conduit so to guarantee the exhaustion of this air stream and so the exhaustion of its action of thrust.

Then, once closed the second air blast, while going along the short distance between the sleeve and the point of the duct where the action of thrust of the piston is beginning -(all this takes place under the action of the first air blast) - the components cannot any more acquire a considerable speed and therefore their impact with any fixed part of the station will not absolutely be violent and it will not cause damages to the component.

In fact, inside the duct of the apparatus according to the invention, the components proceed - nearly for inertia -after having received a brief initial thrust from the first air blast, which then partially or completely vents outside, through the holes of the sleeve, when the components -proceeding in their motion - have made open all the apertures.

Lastly it must be observed that the various movements of the components in the duct do not absolutely preclude the possibility of carrying out - in a second stage - a their precise positioning in respect to the robotized arm.

On the contrary, in the known stations, it is not foreseen any means in order to reduce the speed of the arriving components and so, if these components have a considerable kinetic energy, it is very probable that their impact against any fixed parts such as, for instance, a centering element of the component on the coining support, causes their damage.

Even a particular embodiment of a station according to the invention has been described, it is also understood that it includes in its scope any other possible variation accessible to a technician skilled in the art.

## Claims

1) Arrival and positioning station for axial electrical components (2), coming from a store through a conduit (3), for the manipulation of the same by a movable robotized arm, comprising:
- a support (12) for the components (2) positioned immediately downstream the outlet end (4) of the conduit (1);
- a device (7, 8, 9) for the centering of the components (2) on the support (12);
said station, being characterized by the presence of braking means for the components positioned in a duct (1) constituting the final part of the conduit (3) coming from the store.

2) Arrival and positioning station for axial electrical components (2) as in claim 1, characterized by the fact that the braking means comprise:
- a shutter (8) for the outlet end (4) of the duct (1);
- an aperture (11) provided inside the duct (1) near the outlet end (4) in communication with an adjustable air blast acting in opposed direction to that of the movement ot the arriving components (2);
- at least a hole (6), communicating with the outside, obtained in correspondence of the inlet end of the duct (1).

3) Arrival and positioning station for axial electrical components (2) as in claim 2, characterized by the fact that the shutter of the outlet end (4) of the duct (1) is constituted by a piston (8) that slides in a cylinder (7) communicating with the duct (1) in its part near to the outlet end (4) of said duct, such a piston (8) constituting also the device (7, 8, 9) for centering on the support (12), inside a housing element (14, 15), of the component (2) arrived in the portion near the outlet end (4) of the duct (1).

4) Arrival and positioning station for axial electrical components (2) as in claim 3 characterized by the fact that the housing element (14, 15) of the component positioned on the support is a tubular body constituting the final part of the duct, said tubular body being constituted by two half-tubes (14, 15) hinged one to another and normally locked together by springs (22), said half-tubes (14, 15) being provided with pins (21) interacting with a mechanism of aperture comprising a lever (30) actioned by the movement of the robotized arm, for determining the aperture of said half-tubes (14, 15).

Fig. 2

Fig. 1

Fig. 3

EP 0 319 795 A2